# EUROPEAN PATENT APPLICATION

(11) **EP 1 473 597 A2**
(43) Date of publication of application: **03.11.2004**
(21) Application number: 04252438.9
(22) Date of filing: 27.04.2004
(51) Int. Cl.: G03F 7/20

(54) **Lithographic apparatus, device manufacturing method and angular encoder**

(30) Priority: 29.04.2003 EP 03252746
(71) Applicant: ASML Netherlands B.V., 5504 DR Veldhoven (NL)
(72) Inventor: Leenders, Martinus Hendrikus Antonius, 3039 ER Rotterdam (NL); Meijer, Hendricus Johannes Maria, 5506 CA Veldhoven (NL); Van Der Pasch, Engelbertus Antonius Fransiscus, 5688 EG Oirschot (NL); Renkens, Michael Jozef Mathijs, 6135 HC Sittard (NL); Ruijl, Theo Anjes Maria, 5625 LS Eindhoven (NL)
(74) Representative: Leeming, John Gerard

(57) **Abstract**

In a lithographic projection apparatus, a measuring system for measuring the position of the projection system PL relative to a reference frame RF includes sensors rigidly mounted in relation to counterpart sensors of a measuring system measuring the substrate table WT position. An angular encoder which sends light from a target 41 down two optical paths having opposite sensitivities to tilt is used to measure rotation of the projection system PL about its optical axis.

## Description

The present invention relates to lithographic projection apparatus and to device manufacturing methods.

The present invention also relates to an angular encoder.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In known lithographic projection apparatus that carry out scanning exposures, the positions of the mask stage and the substrate stage are measured relative to the projection system (lens) in order to control the stage positions during the scan. In practice, the positions are measured using interferometers mounted on a rigid reference frame to which the projection lens system is rigidly connected. However, in a proposed lithographic projection apparatus using EUV radiation as the exposure radiation the projection system, a mirror system with positive magnification is compliantly mounted in six degrees of freedom to the reference frame as otherwise the requirements on the lens dynamics would be too onerous. The same applies in other types of lithography apparatus. It is therefore necessary to measure the position of the projection system relative to the reference frame as well as the position of the tables relative to the reference frame. A convenient arrangement to do this is required.

It is an object of the present invention to provide a lithographic apparatus with an improved arrangement for measurement of the position of the projection system relative to a reference frame.

According to the invention, there is provided a lithographic projection apparatus comprising:
- a radiation system for providing a projection beam of radiation;
- a support structure for supporting a patterning device, the patterning device serving to pattern the projection beam according to a desired pattern;
- a substrate table for holding a substrate;
- a projection system for projecting the patterned beam onto a target portion of the substrate;
- a reference frame; and
- a first measuring system for measuring positions and/or displacements of said substrate table relative to said reference frame, said measuring system including a plurality of first sensors mounted on said reference frame and having respective measurement axes.
characterized by:
- a second measuring system for measuring positions and/or displacements of said projection system relative to said reference frame, said measuring system including a plurality of second sensors mounted on said reference frame and having respective measurement axes,
- wherein at least one sensor of the second measuring system has a measurement axis passing through an invariant point of said projection system.

By measuring the position of the projection system on a measurement axis passing through an invariant point, that is a point about which a rotation of the projection system does not cause a translation of the image, calculation of the necessary corrections is simplified and the number of sensors necessary can be reduced.

The invariant point is located in the center of the object or image field of the projection system and may form the origin of a coordinate system used in control of the apparatus.

Preferably, the second measuring system comprises three linear sensors measuring along measurement axes passing through said invariant point. In this way the advantages are obtained for all the linear degrees of freedom. In such an arrangement, it is desirable also to have a sensor to measure rotation about the optical axis of the projection system if the patterning device is connected, either rigidly or by servos, to the projection lens and the projection lens is flexibly connected to the reference frame.

Preferably, at least one sensor of said second measuring system has a measurement axis corresponding to a measurement axis of the first measuring system and is mounted rigidly in relation to the corresponding sensor of the first measurement system. In some cases, the measurement axes of the first and second measuring systems will not be exactly parallel. In such a case, two axes would be considered to correspond if they are in a common plane that also contains the Z axis.

Preferably a sensor of the second measurement system, measuring the position of the projection system, that mainly measures a given degree of freedom is mounted on the reference frame rigidly with a high stiffness, i.e. relative to the sensor of the first measuring system, measuring the position of the substrate table, that mainly measures the corresponding degree of freedom, the arrangement of sensors can be made more compact and the crosstalk between sensors minimized. Accordingly, the requirements on relative positional stability of the sensors in each system can be reduced.

Most preferably, a self-contained set of sensors is mounted on a single rigid mount. A self-contained set of sensors is one that does not need to refer to other position or displacement sensors in order to provide their measurements. Thus if, for example, Rz is measured by two spaced-apart linear interferometers with beams parallel to the X direction, both interferometers would be mounted on the single rigid mount. Of course, an interferometer model may take account of the outputs of environmental sensors, e.g. temperature, pressure, humidity, that need not be mounted on the rigid mount.

It should be noted that not all the parts of a sensor need be connected rigidly to the reference frame or the corresponding sensor in the other measuring system; only the critical parts, such as the interferometer and provisions for supply of the measurement beam of an interferometric measurement system or the encoder head of an encoder-type detector, need be mounted on the reference frame. Other parts of the sensors, especially parts which might generate heat, vibration or electrical noise, may be located remotely, if possible.

Preferably, the sensors of the second measuring system mainly measuring the three translational degrees of freedom, X, Y and Z, are rigidly connected to their counterparts in the first measuring system. It will be appreciated that because of volume and layout constraints in an embodiment of the invention, it may not be possible to position sensors such that their measurement axes are exactly parallel to the axes of the frame of reference of the apparatus, hence the fact that a given sensor "mainly" measures one degree of freedom, but its output will require correction using the output of another sensor or sensors to compensate for the fact that its measurement axis is not exactly parallel to an axis of the frame of reference.

Preferably, rotation of the projection system about its optical axis is measured by a sensor that makes a direct measurement of angle.

According to a further aspect of the invention there is provided a device manufacturing method comprising the steps of:
- providing on a substrate table a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material using a projection system; and
- measuring positions and/or displacements of said substrate table relative to a reference frame using a first measuring system including a plurality of first sensors mounted on said reference frame and having respective measurement axes;
characterized by the further step of:
- measuring positions and/or displacements of said projection system relative to a reference frame using a second measuring system including a plurality of second sensors mounted on said reference frame and having respective measurement axes; and in that
- at least one sensor of the second measuring system has a measurement axis corresponding to a measurement axis of a sensor of the first measuring system and is mounted rigidly in relation to the corresponding sensor of the first measuring system.

The present invention also provides an angular encoder comprising:
- a target;
- an optical module comprising: a first beam splitter for directing light from said target into first and second optical paths, an optical element in at least one of said optical paths whereby one of said paths has an opposite sensitivity to tilt than the other of said optical paths, and means for recombining light from said first and second optical paths and projecting two overlapping images of said target;
- whereby relative rotation of said target and said optical module causes relative movement of said two overlapping images.

This arrangement provides a single signal that is indicative of the relative rotation of the target and optical module, rather than two signals representing linear movements which must then be processed to give an indication of angle. Also, the sensitivity of the device is not limited by the arm that can be provided between two linear measurements, rather the opposite angle sensitivity of the two optical paths serves to amplify the signal.

Preferably the target is a grating whereby Moiré effects are formed in the overlapped images. The optical element may comprise a prism having a pentagonal cross-section in which the beam traveling one optical path undergoes two internal reflections and crosses itself.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning device" used herein should be broadly interpreted as referring to a device that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning devices may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning device".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which:
Figure 1 depicts a lithographic projection apparatus according to a first embodiment of the invention;
Figures 2 and 3 are diagrams showing the invariant points of projection systems with magnifications of -M and +M respectively;
Figure 4 is a diagram indicating measurement axes of sensors in a first embodiment of the invention;
Figure 5 is a diagram indicating measurement axes of sensors in a second embodiment of the invention;
Figure 6 is a diagram indicating measurement axes of sensors in a third embodiment of the invention;
Figure 7 is a diagram indicating measurement axes of sensors in a fourth embodiment of the invention;
Figure 8 is a diagram indicating measurement axes of sensors in a fifth embodiment of the invention;
Figure 9 is a diagram indicating measurement axes of sensors in a sixth embodiment of the invention;
Figure 10 is a diagram indicating measurement axes of sensors in a seventh embodiment of the invention;
Figure 11 is a diagram indicating measurement axes of sensors in a eighth embodiment of the invention;
Figure 12 is a diagram indicating measurement axes of sensors in a ninth embodiment of the invention;
Figure 13 is a diagram of an angular encoder according to the present invention; and
Figure 14 depicts an arrangement for measuring the z-position of the optical axis of the projection system.

In the Figures, corresponding reference symbols indicate corresponding parts.

### Embodiment 1

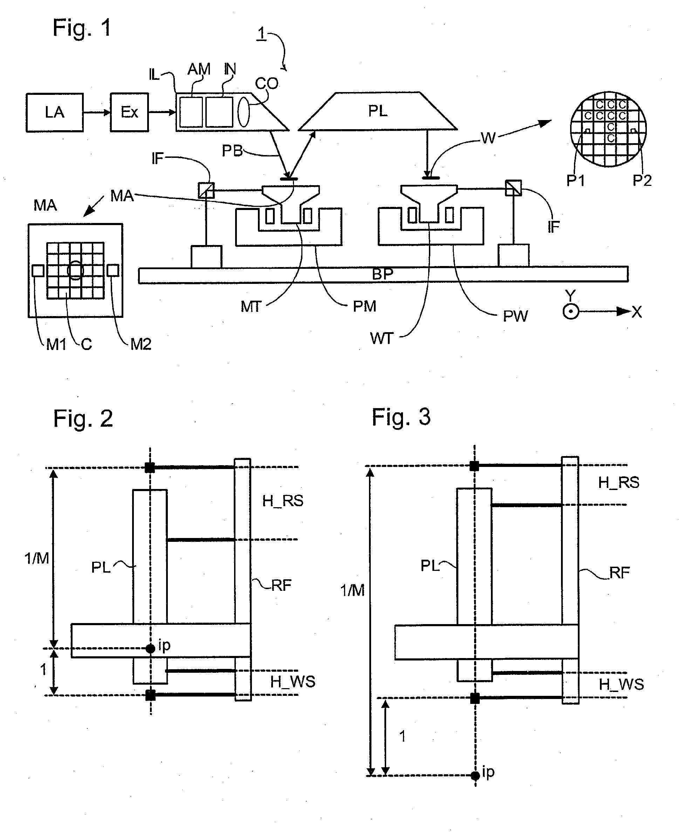

Figure 1 schematically depicts a lithographic apparatus according to a particular embodiment of the invention. The apparatus comprises:
- an illumination system (illuminator) IL for providing a projection beam PB of radiation (e.g. UV or EUV radiation).
- a first support structure (e.g. a mask table) MT for supporting a patterning device (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as σ-outer and σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the projection beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes a programmable patterning device, such as a programmable mirror array of a type as referred to above.
Combinations and/or variations on the above described modes of use or entirely different modes of use may also be employed.

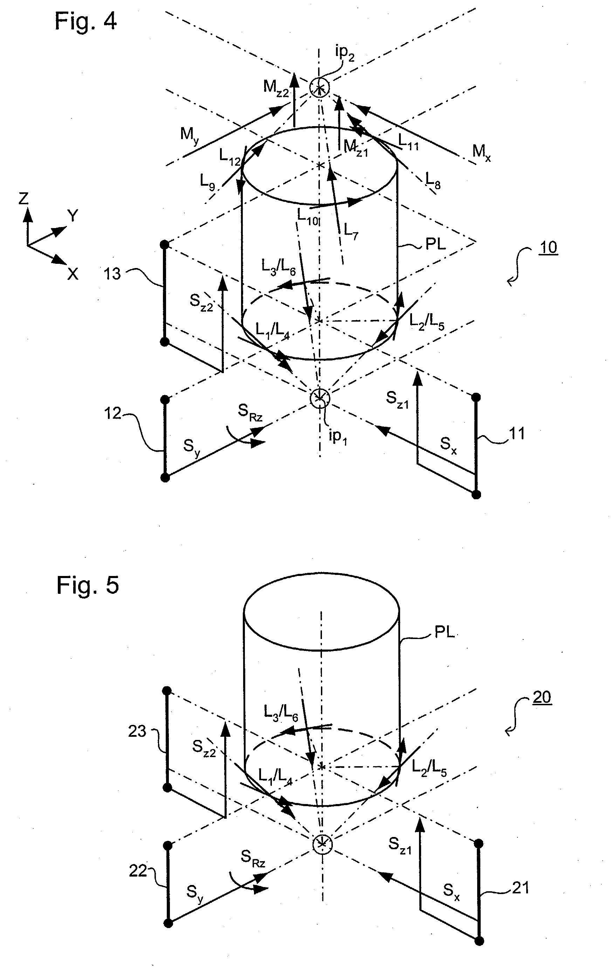

Figures 2 and 3 show the positions of the tilt-invariant points of projection systems having a magnification of-M and +M respectively (M<1) and where the measuring systems for substrate and patterning means are rigidly attached to a reference frame and measure the positions of the substrate and patterning device relative to the projection system bottom and projection system top respectively. A rotation of the projection system about a tilt-invariant point does not result in an image translation. A translation relative to the tilt-invariant point does cause an image displacement. A rotation about a point away from the tilt-invariant point can be decomposed into a rotation about the tilt-invariant point and a translation, which can then be compensated for. M, for example may be ¼. With inverting magnification (sometimes referred to as a negative magnification), as shown in Figure 2, the tilt-invariant point ip is within the projection system PL and by positioning reference beams suitable distances, H_WS and H_RS, above and below the substrate and mask tables, an interferometer based system for measuring the positions of the substrate and mask tables relative to the projection system PL can be made to automatically take account of some rigid body motions of the projection system. However, as shown in Figure 3, for a non-inverting system (positive magnification), the tilt invariant point is below the substrate stage and so the same arrangement cannot be used unless reference beams can be directed against the projection system above the mask table or below the substrate table, *i.e.* parts of the projection system must extend above and below the mask and substrate tables, which is impractical. This also applies to systems - whether inverting, non-inverting or inverting in one direction and non-inverting in the other - with either the patterning device or substrate measuring system attached to an extremity of the projection lens. Accordingly it is necessary to separately measure the position and/or displacements of the projection lens and calculate the effects of any movements on image positioning, which can then be taken account of in the control of the mask and substrate table positions during and exposure. An arrangement 10 of sensors to accomplish this is described below with reference to Figure 4.

Other arrangements of the reference frame and measuring systems may have other tilt invariant points. For example, if the projection system is non-rigidly coupled to a reference frame that carries two measuring systems - one for measuring the position of the substrate or the patterning device relative to the frame and one for measuring the projection system relative to the frame - there will be a tilt invariant point in the centre of the image or object fields. With three measuring systems two invariant points may be defined.

It should be noted that the projection system PL, and its frame (which may be referred to below as the projection optics box), is not rigidly connected to the reference frame. Instead there is a compliant connection with a frequency of about 30Hz for example and allowing displacements of the order of 100nm, for example. Measurements are then taken from the reference frame of the positions of the object tables WT, MT and the projection system PL.

In this embodiment, the positions of the substrate table WT and the bottom of the projection system PL are measured relative to a Cartesian (XYZ) coordinate system having an origin at the intersection of the optical axis of the projection system PL and its focal plane. The lower invariant point ip₁ is shown ringed in Figure 4. The position and orientation of the substrate stage is measured in the translation directions X, Y and Z and in rotation about the Z axis, Rz, by sensors mounted on sensor blocks 11, 12 and 13 and having measurement axes Sₓ, Sy, S_{z1}, S_{z2}, and S_{Rz} as shown in the Figure. Two Z measurement sensors are used because it is inconvenient to arrange a Z measurement axis that passes through the origin. The sensor blocks 11, 12 and 13 are especially stable parts of the reference frame RF. For example, the sensor blocks can be formed of inserts of a low CTE material, such as Zerodur ^{TM}, ULE^{TM}, ClearCeram^{TM}, Invar, or the like, in the reference frame. Other construction materials such as stainless steel, aluminum may also be used if active stabilization (temperature control) is applied. Other materials may also be used if the thermal time constant of the reference frame is substantially longer than the time between calibration of object to image shifts or if the thermally induced shift is predicted using a feed forward model.

Simultaneously, the positions of the mask table MT and the top of the projection system PL are measured relative to a Cartesian coordinate system having an origin on the optical axis of the projection system and in the nominal object plane. The position of the mask table MT is measured using sensors having measurement axes Mₓ, My, M_{z1} and M_{z2} in a similar manner to the measurement of the substrate table WT position. Rotation of the mask table about the Z axis (M_{Rz}) can be provided by combining two Y measurements or with an angle encoder, for example as described below..

At the bottom of the projection system a set of sensors 10 is provided to measure the position of the projection system PL relative to the lower invariant point ip₁. These sensors have six measurement axes L₁ to L₆ which are grouped in pairs: L₁/L₄, L₂/L₅, L₃/L₆. One of the measurement axes of each pair, L₁ L₂ L₃, passes through the lower origin ip₁ whilst, conveniently, the other of each pair, L₄ L₅ L₆, is substantially orthogonal. The signals from these sensors can thus be combined to determine the position of the bottom end of the projection system PL relative to the lower invariant point ip₁. The sensors may comprise three two-dimensional (or three pairs of one-dimensional) encoders mounted on the reference frame RF at positions approximately 120° apart.

At the top of the projection system PL a similar arrangement is provided with sensors having measurement axes L₇ to L₁₂. Again these are paired with one measurement axis of each pair passing through the upper invariant point ip₂ (ringed in Figure 4) and the other of each pair being substantially orthogonal to the first of each pair.

It will be apparent that the above system has considerable redundancy of measurement, which may be reduced.

### Embodiment 2

In a second embodiment of the invention, which is the same as the first embodiment save as described below, a single reference frame is used.

Figure 5 shows the arrangement at the bottom of the projection system PL - this has an arrangement of sensors 20 mounted on sensor blocks 21, 22, 23 that is essentially the same as in the first embodiment. However, no sensors are mounted at the top of the projection system PL, instead the position of the mask table is measured using interferometers (not shown) mounted on the projection lens. This arrangement reduces the number of redundant sensors but the accuracy of the measurements is dependent on the relatively long path through the reference frame between mask level and substrate level. Thermal drift and dynamic movement of the reference frame must therefore be reduced further.

### Embodiment 3

In a third embodiment of the invention, which may be the same as the first embodiment of the invention save as described below, the sensors for measuring the position of the projection system are mounted rigidly and thermally stably, in relation to corresponding substrate table position sensors.

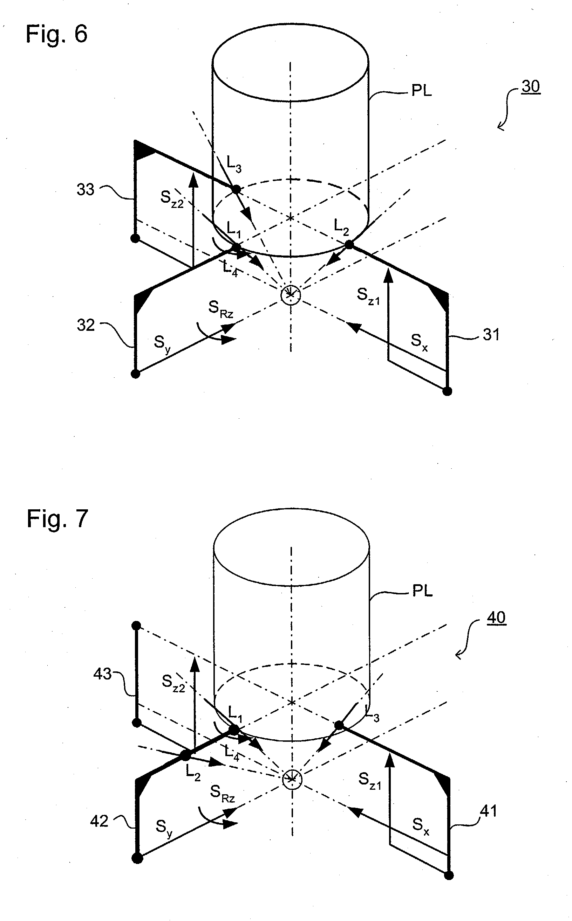

As shown in Figure 6, the substrate table position in X, Y, Z and Rz is measured by sensors having measurement axes Sₓ, S_{y}, S_{z1}, S_{z2} and S_{Rz} arranged in the same way as in embodiment 1.

The positions and orientation of the projection system PL in the same four degrees of freedom are measured by sensors having measurement axes L₁ to L₄, also shown in Figure 6. Axis L₁ is measured by a sensor mounted on measurement block 32, to which the sensor for measuring displacements of the substrate table in the Y direction is mounted, and mainly measures displacements of the projection system PL in the Y direction. Measurement axis L₁ is necessarily inclined to the Y direction and hence the measurement will include some dependence on Z displacements which is subtracted by reference to measurements on axes L₂ and L₃. Likewise, the sensors measuring on measurement axes L₂ and L₃, which mainly measure the displacements in the X and Z directions, are mounted on sensor blocks 31 and 33 to which are also mounted the sensors for measurement of X and Z displacements of the substrate table. Measurement axis L₄ is a direct measurement of the angle of rotation of the projection lens about the Z axis and is measured by a sensor mounted to sensor block 32 to which the sensor for Rz movements of the substrate table is also connected. An angular encoder suitable for making such a measurement is described below.

With the sensor in this arrangement, the sensors for projection system position are mounted in a plane at the bottom of the projection system and close to the plane of the substrate table position sensors. Sensors with a ratio of active range to resolution in the range of 10³ to 10⁴ can be used, meaning that a wide variety of sensors can be used, e.g. interferometers, or encoders (linear or 2D).

It will be appreciated that if the movements of the projection lens system relative to the reference frame in a given direction, e.g. Rx, Ry, can be assumed to be sufficiently small, measurement in that direction may be omitted.

### Embodiment 4

A fourth embodiment of the invention, which is the same as the third embodiment save as described below, use a modified arrangement of sensors for measuring the position and/or displacements of the projection system PL. This different arrangement 40 is shown in Figure 7.

In the fourth embodiment of the invention, measurement axes L₁ and L₄ are the same as in the third embodiment. However, the sensor for measurement axis L₂ is instead mounted on the sensor block 42 to which the Y sensor for the substrate stage is attached, spaced from the sensor for measurement axis L₁. Measurement axes L₁ and L₂ thereby provide measurement of the Y and Z positions of the projection system. The sensor for measurement axis L₃ is mounted on the sensor block 41 carrying the X sensor for the substrate table and, corrected for Z displacements, provides information as to movements in X of the projection system. The sensors for measurements of two linear degrees of freedom, Y and Z, are therefore combined on a single sensor block so that no projection system sensor need be positioned on sensor block 43, which carries the second Z sensor for the substrate table. This allows for a more compact arrangement of sensors and additional design freedom. This arrangement is also less sensitive to thermal drift and the dynamics of the reference frame.

### Embodiment 5

A fifth embodiment of the invention, which may be the same as the third save as described below, omits certain measurements and may be used where the corresponding movement so the projection system are expected to be small.

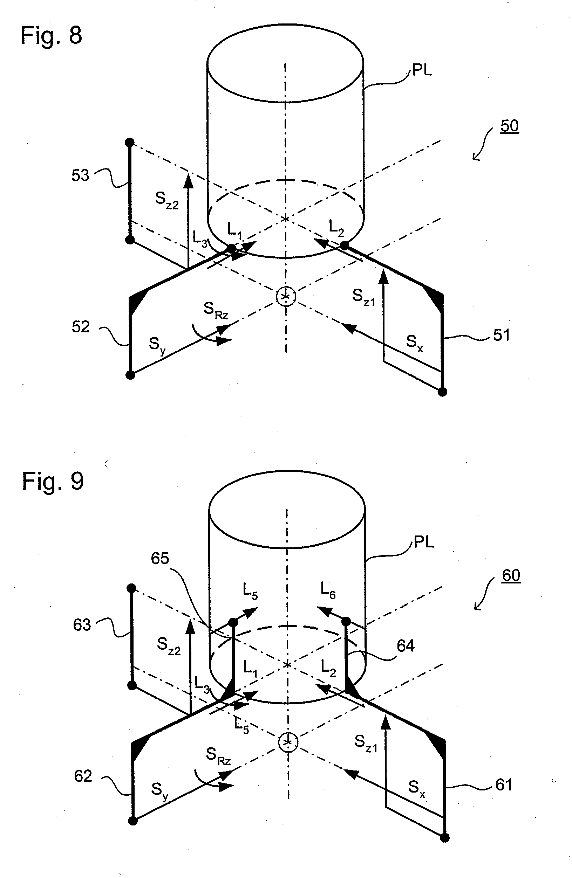

As shown in Figure 8 the sensor system 50 comprises substrate table position sensors that are the same as the third embodiment. The position sensors for the projection system are mounted on sensor blocks 51, 52 to which corresponding substrate table sensors are mounted but only measure X, Y and Rz movements of the projection system using measurement axes L₂, L₁ and L₃ respectively. No measurement of Rx, Ry and Z position of the projection system is made and this embodiment is therefore used only when movements in these directions can be assumed small enough.

### Embodiment 6

A sixth embodiment of the invention is based on the fifth but additionally measures the Rx and Ry position of the projection lens.

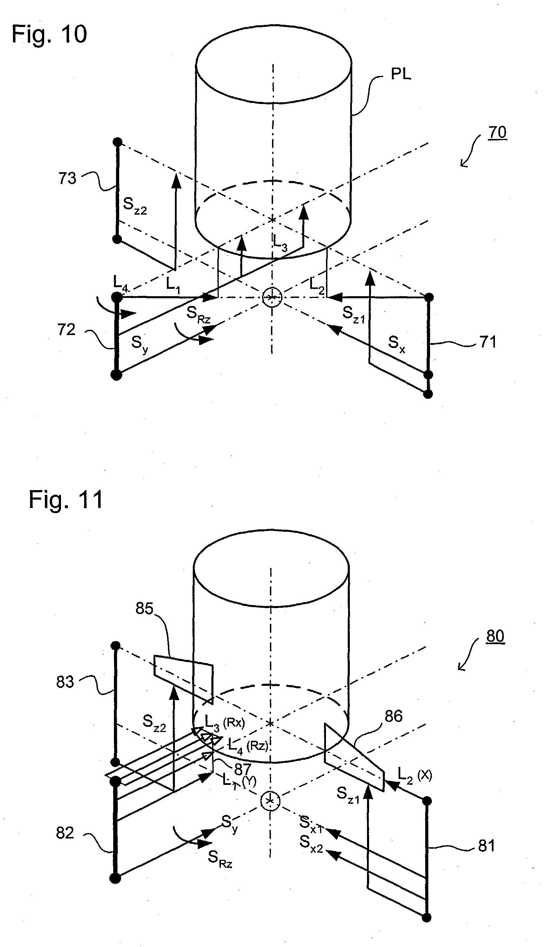

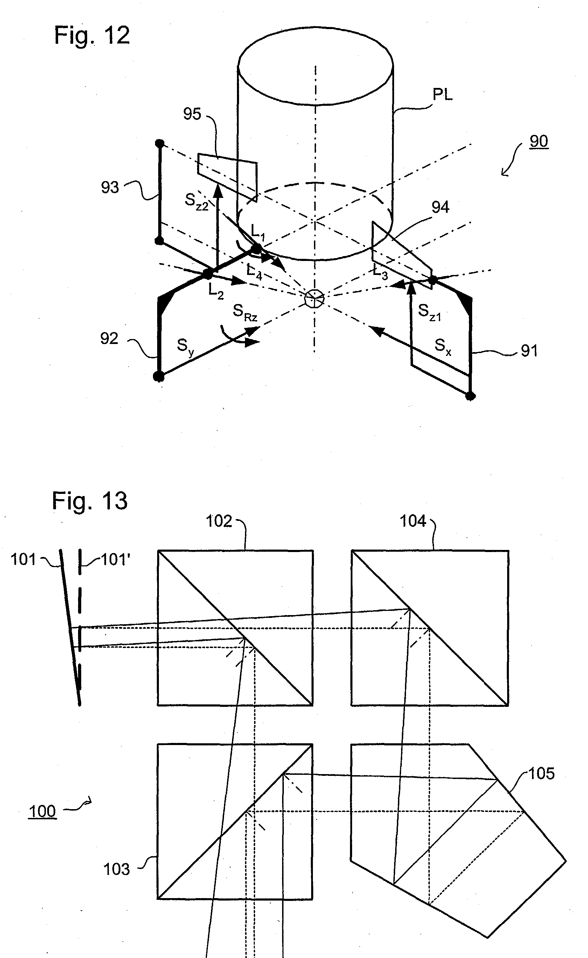

As can be seen from Figure 9, the sixth embodiment is the same as the fifth except that the sensor system 60 additionally comprises measurement axes L₅, L₆ which measure X and Y movements of the projection system at locations spaced in Z from axes L₁, L₂ and can thus be used to derive measurements of the movements of the projection system in Rx and Ry. The respective sensors are mounted on rigid extensions 64, 65 of sensor blocks 61, 62 respectively. A Z lens measurement may be included by providing two measurement axes S_{z1} and S_{z2} directed against mirrors attached to either side of the projection lens, as shown in Figures 11 and 12.

### Embodiment 7

A seventh embodiment of the present invention, which is the same as the third embodiment save as described below, uses a further alternative arrangement of sensors 70 for projection system measurement, shown in Figure 10.

In the seventh embodiment, interferometers are used to measure the translational degrees of freedom of the projection system PL. Measurement axes L₁ and L₂ are inclined to the XY plane and measured by interferometers directing beams from sensor blocks 72 and 71 respectively onto mirrors mounted on extensions (not shown) of the reference frame. Sensor block 72 also carries components to direct interferometer beams to two symmetric positions about the projection system center to make a differential measurement of the Z position of the projection system.

### Embodiment 8

An eighth embodiment of the invention, which may be the same as the first save as described below, employs a sensor system 80 that corrects for the Abbé arm between the substrate and the axis for measurement of the projection system position in X. In this embodiment, X, Y, Rz and Rx are measured from eth reference frame to the projection lens and substrate stable whilst Z and Ry are measured directly between projection lens and table.

The sensor system 80 is shown in Figure 11 and employs a substrate stage position measurement system which is the same as that of the first embodiment.

The projection system measurement system has measurement axes L₁ and L₂ for Y and X respectively, and axes L₃ and L₄ for Rx and Rz.

Axes L₁, L₃ and L₄ are measured by sensors mounted on sensor block 82, which also mounts the sensors for measurement of the substrate table Y and Rz position - S_{y} and S_{Rz}. These sensors comprise interferometers with beams directed against a mirror mounted on the projection system PL. For convenience of layout, that mirror may extend below the bottom of the projection system PL. The interferometers for Rx and Rz involve two beams each (indicated with open-headed arrows) directed against the mirror at positions spaced apart in a direction orthogonal to the axis about which they measure rotation.

Axis L₂ is measured by an interferometer mounted on sensor block 81 which also mounts sensors for substrate table measurement axes Sₓ₁, Sₓ₂, which measure Ry of the substrate stage. The interferometer conveniently directs its beam against one of the horizontal mirrors 85, 86 used for the substrate table Z measurement. The two Z axes measure Ry of the substrate stage with respect to the projection optics box. The mirrors 85, 85 are fixed to the projection optics box whilst sensor blocks 81, 82 and 83 are fixed to the reference frame.

To correct for the Abbé arm, the known rotation of the projection optics box about the Y axis, Ry-POB, is used. The change in X is given by the product of Ry-POB and the Abbé arm, i.e. the distance in Z from measurement Axis L2 to the center of the image field.

All interferometer areas in this arrangement are orthogonal, simplifying the calculation of the position information and avoiding cross-talk between degrees of freedom.

### Embodiment 9

A ninth embodiment of the invention is similar to the fourth embodiment but the reference mirrors for the substrate table Z measurement are mounted to the projection system PL.

The sensor arrangement 90 is shown in Figure 12. For the substrate table position measurement, sensors for measurement axes Sₓ and S_{z1} are attached to sensor block 91, for S_{Rz} and S_{y} are attached to sensor block 92 and for S_{z2} are attached to sensor block 93. The sensors for projection system measurement axes L₁, L₂ and L₄ are attached to sensor block 92 and L₃ is attached to sensor block 91. Sensor block 91, 92 and 93 are fixed to the reference frame whilst mirrors 94, 95 are fixed to the projection optics box.

### Angular Encoder

An angular encoder useable in the embodiments described above, and in other applications in lithography and other technical fields, is shown in Figure 13.

The encoder comprises an optical module 100 and a target 101 which are mounted on the two parts whose relative angular position is to be measured. Note that the encoder measures changes in relative angle, for measurement of absolute angle a calibration is required. For example, the target 101 may be mounted on the projection system and the optical module 100 on the reference frame or vice versa. In this embodiment, the target 101 is a grating, either a transmission grating illuminated from behind or a reflection grating illuminated from the front. Light from the grating enters the optical module 100 where it is divided to travel along two optical paths by a first beam splitter 102. The light on the first path passes directly to second beam splitter 103 which recombines the beams from the two paths. The second optical path is folded by third beam splitter 104 and passes through prism 105 before being recombined with the first optical path by second beam splitter 103. Prism 105 is pentagonal in cross-section and arranged such that the beam following the second optical path undergoes two internal reflections in the prism and crosses over itself.

As can be seen in the Figure by comparing the solid ray traces representing the situation when the grating 101 is in the position indicated by a solid line with the dashed ray traces indicating the situation when the grating is in position indicated by a dashed line 101', the first and second optical paths have opposite sensitivity to relative angular movement (tilt) between the target 101 and the optical module 100. Thus, when the beams from the two paths are focused in to images of the target by suitable optics (not shown) the images of the target deriving from the two paths will move in opposite directions. Moiré patterns are formed in the overlapped images and can easily be detected to measure tilt and changes in tilt between the target and optical module.

### Measurement of Z-Motion of Projection system

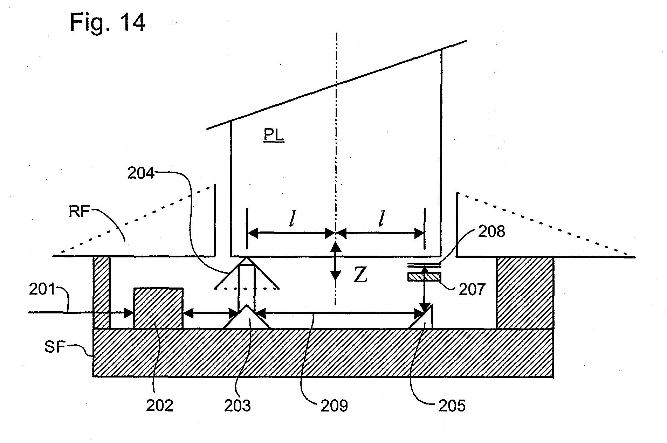

An arrangement for measuring the Z-position of the optical axis of the projection system is shown in Figure 14. This may be used in any of the embodiments of the invention described above. An input/output beam 201 is supplied to a plane mirror, double beam interferometer 202 with internal reference mirror. The measurement beam is directed along measurement beam path 209 in which prism 203 directs the beam through ninety degrees to corner cube 204 mounted on the projection lens and also directs the returned beam back onto measurement path 209. Bending mirror 205 directs the beam at ninety degrees to a 1/4 wave plate 207 and then reflecting mirror 208 mounted on the projection lens. The comer cube 204 and reflecting mirror 208 are both mounted a distance l from the optical axis, indicated by the chain line. The interferometer 202, prism 203 and bending mirror 205 are all mounted on a subframe SF which is connected to the reference frame RF.

Whilst specific embodiments of the invention have been described above, it will be appreciated that the invention may be practiced otherwise than as described. For example, the various sensor arrangements described for measuring the position and/or displacements of the substrate table may also be applied with suitable modifications for measuring the positions and/or displacements of the mask table. The description is not intended to limit the invention.

## Claims

1. A lithographic projection apparatus comprising:
- a radiation system for providing a projection beam of radiation;
- a support structure for supporting a patterning device, the patterning device serving to pattern the projection beam according to a desired pattern;
- a substrate table for holding a substrate;
- a projection system for projecting the patterned beam onto a target portion of the substrate;
- a reference frame; and
- a first measuring system for measuring positions and/or displacements of said substrate table relative to said reference frame, said measuring system including a plurality of first sensors mounted on said reference frame and having respective measurement axes.
**characterized by**:
- a second measuring system for measuring positions and/or displacements of said projection system relative to said reference frame, said measuring system including a plurality of second sensors mounted on said reference frame and having respective measurement axes,
- wherein at least one sensor of the second measuring system has a measurement axis passing through an invariant point of said projection system.

2. Apparatus according to claim 1 wherein said projection system is non-inverting.

3. Apparatus according to claim 1 or 2 wherein said second measuring system comprises three linear sensors measuring along measurement axes passing through said invariant point.

4. Apparatus according to claim 3 wherein a first and a second one of said three linear sensors are rigidly mounted to the same mount at spaced apart locations.

5. Apparatus according to claim 3 or 4 wherein said three linear sensors are linear encoders.

6. Apparatus according to claim 3, 4 or 5 wherein said second measurement system further comprises a sensor that makes a direct measurement of angle.

7. Apparatus according to claim 3, 4, 5 or 6, wherein said second measuring system further comprises three further sensors each having a measurement axis substantially orthogonal to the measurement axis of a respective one of said three linear sensors so as to form a measurement system capable of measuring six degrees of freedom..

8. Apparatus according to any one of the preceding claims wherein at least one sensor of said second measuring system has a measurement axis corresponding to a measurement of the first measuring system and is mounted rigidly in relation to the corresponding sensor of the first measurement system.

9. Apparatus according to claim 8 wherein the sensors of the second measuring system mainly measuring the three translational degrees of freedom, X, Y and Z, are stably connected to their respective counterparts in the first measuring system.

10. Apparatus according to claim 8 or 9 wherein sensors of the second measuring system that are mounted stably in relation to counterparts in the first measuring system are mounted on the same block of material as their counterparts.

11. Apparatus according to claim 10 wherein said material is a material having a low coefficient of thermal expansion such as Zerodur™, ULE™, ClearCeram™ or the like.

12. Apparatus according to claim 9 wherein said sensors of the second measuring system that are mounted stably in relation to counterparts in the first measuring system are mounted on a subframe provided with active temperature stabilization.

13. Apparatus according to any one of claims 8 to 12 wherein said second measuring system comprises a sensor mainly measuring in the Y direction and rigidly mounted to a sensor of the first measuring system measuring the substrate table position in the Y direction, two sensors mainly measuring in the X and Z directions and rigidly connected to sensors of the first measuring system measuring in the X and Z directions.

14. Apparatus according to any one of claims 8 to 12 wherein said second measuring system comprises a sensor mainly measuring in the X direction and rigidly mounted to a sensor of the first measuring system measuring the substrate table position in the X direction, two sensors mainly measuring in the Y and Z directions and rigidly connected to a sensor of the first measuring system measuring in the Y direction.

15. Apparatus according to any one of claims 8 to 12 wherein said second measuring system comprises a first interferometer mainly measuring in the Y direction and rigidly mounted to a sensor of the first measuring system measuring the substrate table position in the Y direction, a second interferometer mainly measuring in the X direction and rigidly connected to a sensor of the first measuring system measuring in the X direction and a third interferometer measuring purely in the Z direction and mounted rigidly to the sensor of the first measuring system measuring in the Y direction.

16. Apparatus according to any one of the preceding claims wherein said second measuring system comprises an angular encoder comprising:
- a target;
- an optical module comprising: a first beam splitter for directing light from said target into first and second optical paths, an optical element in at least one of said optical paths whereby one of said paths has an opposite sensitivity to tilt than the other of said optical paths, and means for recombining light from said first and second optical paths and projecting two overlapping images of said target;
- whereby relative rotation of said target and said optical module causes relative movement of said two overlapping images.

17. A device manufacturing method comprising the steps of:
- providing on a substrate table a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material using a projection system; and
- measuring positions and/or displacements of said substrate table relative to a reference frame using a first measuring system including a plurality of first sensors mounted on said reference frame and having respective measurement axes;
**characterized by** the further step of:
- measuring positions and/or displacements of said projection system relative to a reference frame using a second measuring system including a plurality of second sensors mounted on said reference frame and having respective measurement axes; and in that
- at least one sensor of the second measuring system has a measurement axis corresponding to a measurement axis of a sensor of the first measuring system and is mounted rigidly in relation to the corresponding sensor of the first measuring system.

18. An angular encoder comprising:
- a target;
- an optical module comprising: a first beam splitter for directing light from said target into first and second optical paths, an optical element in at least one of said optical paths whereby one of said paths has an opposite sensitivity to tilt than the other of said optical paths, and means for recombining light from said first and second optical paths and projecting two overlapping images of said target;
- whereby relative rotation of said target and said optical module causes relative movement of said two overlapping images.

19. An angular encoder according to claim 18 wherein said target comprises a grating.

20. An angular encoder according to claim 18 or 19 wherein said optical element comprises a prism having a pentagonal cross-section whereby light traversing said second optical path undergoes two internal reflections in said prism and crosses over itself.
